Europäisches Patentamt

European Patent Office

Office européen des brevets

(19)

(11) **EP 1 285 282 B1**

(12) **EUROPÄISCHE PATENTSCHRIFT**

(45) Veröffentlichungstag und Bekanntmachung des Hinweises auf die Patenterteilung:
**27.04.2005 Patentblatt 2005/17**

(21) Anmeldenummer: **00935080.2**

(22) Anmeldetag: **20.05.2000**

(51) Int Cl.$^7$: **G01R 31/12**

(86) Internationale Anmeldenummer:
**PCT/EP2000/004582**

(87) Internationale Veröffentlichungsnummer:
**WO 2001/090767 (29.11.2001 Gazette 2001/48)**

(54) **VERFAHREN UND VORRICHTUNG ZUR ERKENNUNG VON STÖRLICHTBÖGEN**

METHOD AND DEVICE FOR DETECTING ACCIDENTAL ARCS

PROCEDE ET DISPOSITIF PERMETTANT DE DETECTER DES ARCS ELECTRIQUES ACCIDENTELS

(84) Benannte Vertragsstaaten:
**AT BE CH CY DE DK ES FI FR GB GR IE IT LI LU MC NL PT SE**

(43) Veröffentlichungstag der Anmeldung:
**26.02.2003 Patentblatt 2003/09**

(73) Patentinhaber: **Ellenberger & Poensgen GmbH D-90518 Altdorf (DE)**

(72) Erfinder:
• **MECKLER, Peter**
  **D-91224 Hohenstadt/Pommelsbrunn (DE)**

• **STEFFEN, Peter**
  **D-91058 Erlangen (DE)**
• **KÖHLER, Stefan**
  **D-96472 Rödental (DE)**
• **WILSON, Ho**
  **Seattle, WA 98125 (US)**

(74) Vertreter: **Tergau & Pohl Patentanwälte Mögeldorfer Hauptstrasse 51 90482 Nürnberg (DE)**

(56) Entgegenhaltungen:
**EP-A- 0 639 879        DE-A- 4 029 141
US-A- 5 561 605**

EP 1 285 282 B1

**Beschreibung**

Die Erfindung bezieht sich auf ein Verfahren zur Erkennung von Störlichtbögen an einem Kabel, insbesondere an einem Bordnetzkabel eines Luft- oder Raumfahrzeugs. Sie bezieht sich weiter auf eine Vorrichtung zur Durchführung des Verfahrens. Unter Störlichtbogen wird hierbei insbesondere das sogenannte Arc Tracking verstanden.

Das Problem des sogenannten "Cable Arc Tracking" ist insbesondere bei Bordnetzen in Luft- und/oder Raumfahrzeugen seit Jahren bekannt. Bei diesem Arc Tracking entsteht in einem Kabelbündel zwischen zwei nebeneinander verlaufenden Kabeln aufgrund beispielsweise von Vorschädigungen und/oder Verschmutzungen (Wet Arc Tracking) oder durch Scheuem an einer metallischen Kante (Dry Arc Tracking) eine leitende Verbindung. Diese Verbindung kann zunächst hochohmig (Wet Arc Tracking) oder auch direkt niederohmig (Dry Arc Tracking) sein. Als Wet Arc Tracking wird dabei die durch einen Elektrolyt, z.B. eine Reinigungsflüssigkeit, hergestellte und die Kabelisolation angreifende leitfähige Verbindung zwischen zwei Isolationsfehlern bezeichnet. Die Folge bei Lichtbogenbildung ist häufig eine thermische Zerstörung des gesamten Kabelbündels auf einer bestimmten Länge. Demgegenüber wird beim Dry Arc Tracking die leitende Verbindung durch einen metallischen Leiter relativ niederohmig hergestellt und der Lichtbogen entsteht praktisch sofort. Auch dies kann zur thermischen Zerstörung des Kabelbündels führen.

Problematisch ist dabei nicht nur die Zerstörung des Kabelbündels selbst. Kritisch sind vielmehr daraus resultierende Folgeschäden, die durch in Brand setzen von umgebenden Material entstehen. Die aus derartigen Kabelbränden resultierenden auch explosionsähnlichen Folgefehler können wiederum Ursache katastrophaler Luft- oder Raumfahrzeugschäden sein.

Bei der Ursachenforschung hinsichtlich auftretender Störlichtbögen oder Arc Tracking in Kabeln derartiger Bordnetze konnte nachgewiesen werden, dass einerseits die Widerstandsfähigkeit von Kabelisolierungen gegen Arc Tracking ausschließlich vom Aufbau der beim Kabelmantel verwendeten Materialien abhängt. Andererseits zeichnet sich das bisher verwendete Material (POLYIMID) durch eine sehr hohe Wasseraufnahme aus, wodurch eine Vorschädigung durch Rißbildung in der Isolation, speziell bei häufigen Temperaturwechseln, wie diese im Flugbetrieb auftreten, begünstigt wird. Darüber hinaus werden bei thermischer Zerstörung ab etwa 800°C karbonisierende Beläge gebildet und damit das Arc Tracking, d.h. ein Weiterwandern des Bogens entlang des Kabelbaums, erst ermöglicht. Demgegenüber sind Materialien wie beispielsweise POLYTETRAFLOURETHYLEN (PTFE) relativ resistent gegenüber Arc Tracking.

Da bei den in der Luftfahrt verwendeten Kabeltypen weiterhin die Isolierung aus POLYIMID-Folie besteht, zielen alle bisher auf diesem Gebiet unternommenen Anstrengungen darauf ab, Tests zu entwickeln, die eine möglichst eindeutige Klassifizierung von Kabeln hinsichtlich deren Widerstandsfähigkeit gegen Arc Tracking zulassen. Dabei wurde POLYIMID als Bestandteil von Kabelummantelungen aufgrund seiner hervorragenden dielektrischen Werte und seiner hohen Temperaturfestigkeit bisher nicht ersetzt. Allerdings konnten trotz Optimierung der Prozesse und Anwendung höchster Sorgfalt beim Herstellen und Verlegen der Kabelbündel Unglücksfälle durch Cable Arc Tracking nicht gänzlich vermieden werden. Zudem wurde erkannt, dass auch in Steckverbindern unter Einfluss von Feuchtigkeit und Verschmutzung Überschläge auftreten können, die im ungünstigsten Fall zum Entzünden benachbarter Teile führen.

Bei der Installation von Schutzmaßnahmen kommt erschwerend hinzu, dass die Amplitude des Stromes, der während des Arc Tracking-Vorgangs fließt, insbesondere beim Wet Arc Tracking deutlich unterhalb des Nennstroms üblicherweise installierter Überstrom-Schutzorgane liegen kann mit der Folge, dass diese nicht auslösen. Demgegenüber sind die Amplitudenwerte beim Dry Arc Tracking erkanntermaßen höher. Diese treten jedoch typischerweise intervallartig auf, so dass die umgesetzte Energie häufig nicht ausreicht, um die installierten Schutzorgane auszulösen.

Zur Beherrschung des beschriebenen Problems ist es daher wünschenswert, zu dem bereits vorhandenen konventionellen Überstromschutz im Bordnetz eines derartigen Luftfahrzeugs einen zusätzlichen Schutz vor Störlichtbögen vorzusehen, um die vorhandenen Bordinstallationen möglichst zuverlässig zu schützen.

Der Erfindung liegt daher die Aufgabe zugrunde, ein besonders geeignetes Verfahren zur Erkennung von Störlichtbögen an einem Kabel, insbesondere an einem Bordnetzkabel eines Luft- oder Raumfahrzeugs, anzugeben. Darüber hinaus soll eine zur Durchführung des Verfahrens geeignete Vorrichtung angegeben werden, die in einfacher und insbesondere raumsparender Weise einen besonders zuverlässigen Schutz eines Kabels oder Kabelbündels und/oder eines darüber versorgten Verbrauchers auch gegen Störlichtbögen (Arc Tracking) ermöglicht.

Bezüglich des Verfahrens wird diese Aufgabe erfindungsgemäß gelöst durch die Merkmale des Anspruchs 1. Vorteilhafte Weiterbildungen sind Gegenstand der auf diesen zurückbezogenen Unteransprüche.

Dazu wird ein erfasstes Wechselstromsignal zeitdiskret abgetastet und durch Interpolation vorzugsweise lediglich einer geringen Anzahl von Abtastwerten eine den Wechselstromverlauf nachbildende Winkelfunktion ermittelt, aus der die aktuelle Wechselstromfrequenz abgeleitet wird. Durch Vergleich der aktuellen Wechselstromfrequenz mit einer Referenz- oder Soll-Frequenz wird dann auf einen Störlichtbogen geschlossen und ggf. ein Meldesignal generiert. Die Referenz- bzw. Soll-Frequenz ist dabei die generierte Wechselstromfrequenz, d. h. im bevorzugten Anwendungsfall die Bordnetzfrequenz bzw. die halbe Bordnetzfrequenz. Auch kann eine aus der Soll-Frequenz abgeleitete kritische Frequenz vorgegeben werden. Diese ist beispielsweise eine mehr als zehnprozentige Überschreitung der generierten Wechselstromfrequenz.

Die Erfindung beruht auf der Erkenntnis, dass sich bei Auftreten eines Lichtbogens oder Arc Tracking ein entsprechendes Störsignal einem über die Versorgungsleitung innerhalb des Kabelbündels geführten Signal, d. h. einem sinus- oder kosinusförmigen Wechselstromsignal überlagert, wobei infolge einer Lückung im Signal durch fortwährende Löschung und Wiederzündung des Lichtbogens jede Signalhalbwelle einen charakteristischen Frequenzanteil oberhalb derjenigen Nennfrequenz aufweist, mit der das Bordnetz betrieben wird. Das Arc-Tracking-Signal ist im erfassten Messsignal in Form von Signalspitzen oder Peak's enthalten, die an verschiedenen Stellen der positiven und/oder der negativen Halbwelle des nachfolgend als Kosinus-Signal beschriebenen Messsignals auftreten können. Da derartige Überlagerungen oder Störungen infolge von Arc Tracking im Wesentlichen im Stromsignal und weniger im Spannungssignal erkennbar sind, ist die messtechnische Erfassung des Stromsignals zweckmäßig.

Die Erfindung geht nun von der Überlegung aus, dass ein kontinuierliches Messsignal, dessen Signalverlauf mittels eines A/D-Wandlers zeitdiskret abgetastet wird, aus nur wenigen Werten bzw. Abtastwerten gemäß dem Ansatz:

$$y(t) = y\,\text{max}\cdot\cos(\omega t)$$

$$\omega tl = -\arccos \frac{y(tl)}{y\text{max}}$$

$$\omega tr = \arccos \frac{y(tr)}{y\text{max}}$$

nachgebildet und daraus die aktuelle Frequenz des tatsächlichen Signalverlaufs mit hoher Genaulgkeit abgeschätzt werden kann gemäß der Beziehung:

$$f(t)= \frac{1}{\pi\Delta t}\arccos \frac{y(tl,r)}{y\text{max}}$$

Dazu erfolgt eine Interpolation der als bevorzugte Winkelfunktion angesetzten Kosinusfunktion aus vorteilhafterweise lediglich drei Abtastwerten, nämlich dem Maximalwert ($y_{max}$) und jeweils einem links und rechts neben dem Maximalwert liegenden Abtastwert ($y(t_{l,r})$). Aufgrund der dadurch nur vergleichsweise geringen zu verarbeitenden Datenmenge wird eine besonders geringe Verarbeitungszeit benötigt. Das Verfahren zeichnet sich somit insbesondere durch eine hohe Verarbeitungsgeschwindigkeit aus. Anstelle der Kosinusfunktion kann als Ansatz prinzipiell auch die Sinusfunktion herangezogen werden.

Die beiden zeitlich vor bzw. nach dem Maximalwert liegenden Abtastwerte weisen vorteilhafterweise den gleichen Ordinaten- oder Amplitudenwert auf. Dies wird zweckmäßigerweise durch Verwendung eines vorgegebenen Schwellwertes sichergestellt, der während der Abtastung vom jeweiligen (linken) Abtastwert gerade überschritten und vom jeweiligen (rechten) Abtastwert gerade unterschritten worden ist. Zur weiteren Verarbeitung werden die diesen beiden Abtastwerten zugehörigen Abszissenwerte und damit die entsprechenden Zeittakte herangezogen, d. h. dem Schwellwert wird das jeweilige Zeit-Kriterium oder der entsprechende Zeitwert dieser beiden Abtastwerte zugeordnet.

Bezüglich der Vorrichtung wird die genannte Aufgabe erfindungsgemäß gelöst durch die Merkmale des Anspruchs 12. Vorteilhafte Ausgestaltungen sind Gegenstand der auf diesen rückbezogenen Unteransprüche.

Die mit der Erfindung erzielten Vorteile bestehen insbesondere darin, dass mittels eines entsprechenden Algorithmus durch Interpolation von zweckmäßigerweise lediglich drei Abtastwerten eines zeitdiskret abgetasteten Wechselstromsignals die aktuelle Wechseistromfrequenz abgeschätzt und bei deren Abweichung von einer Soll- oder Bordnetzfrequenz in zuverlässiger und besonders effektiver Weise ein an einem Bordnetzkabel auftretendes Arc Tracking detektiert werden kann. Durch Heranziehung des vorzugsweise um den Faktor Zehn in der Anzahl reduzierten diskreten Stromsignals, das - im Vergleich zum für die Frequenzschätzung aus nur sehr wenigen Abtastwerten interpolierten Signalverlauf - die im erfassten Wechselstromsignal enthaltenen Informationen vergleichsweise vollständig erhält, wird die gesamte Signalverarbeitung und Signalauswertung datentechnisch vereinfacht. Dazu enthält der Algorithmus vorzugsweise zwei parallele Programmpfade, wobei in dem zur Frequenzschätzung vorgesehenen (ersten) Programmpfad von der für eine gewünschte Feinauflösung des Wechseistromsignals bewußt hohen Abtastrate praktisch nur drei Abtastwerte verarbeitet werden. Für den eigentlichen Signalpfad oder (zweiten) Programmpfad wäre ohne signifikanten Informationsverlust eine vergleichsweise geringe Abtastrate ausreichend, so dass zweckmäßigerweise die dort zu verarbeitende Datenrate durch Reduzierung der Anzahl der Abtastwerte des diskreten Stromsignals verringert wird.

Eine nach diesem Verfahren arbeitende Vorrichtung ist vorteilhafterweise in einem Schutzschalter für das Bordnetz eines Luftfahrzeugs integriert, so dass dieser in einfacher und raumsparender Weise zur Erkennung und Abschaltung von an einem Bordnetzkabel auftretenden Störlichtbögen ertüchtigt ist. Dazu wird der entsprechende Algorithmus zweckmäßigerweise in ein sogenanntes ASIC (Application Specific Integrated Circuit) implementiert, das aufgrund dessen geringer Baugröße in einen für diese Anwendung herkömmlichen Schutzschalter mit anforderungsgemäß besonders geringen Abmessungen einsetzbar ist.

Die Vorrichtung eignet sich daher insbesondere zur Erkennung fehlerhafter Lichtbögen, die bei Spannungs-Überschlägen infolge von Isolationsfehlern entstehen. Die zweckmäßigerweise im Bordnetz eines derartigen Luftfahrzeugs dauerhaft installierte Vorrichtung bzw. der um diese Schutzfunktion erweiterte Schutzschalter zeigt somit Lichtbogenfehler an und schaltet ggf. selektiv ab. Dadurch wird zumindest die Brenndauer eines entstandenen Lichtbogens derart reduziert, dass Folgeschäden vermieden sind. Der um diese Schutzfunktion erweiterte Schutzschalter eignet sich somit insbesondere auch zur Nachrüstung in bereits hergestellten und/oder bestimmungsgemäß genutzten Luftfahr- oder Flugzeugen, in denen die herkömmliche Kabelisolierung eingesetzt ist. Eine derartige Nachrüstung ist insbesondere aus wirtschaftlichen Gründen besonders zweckdienlich, da die übliche Betriebsdauer von Flugzeugen derzeit 15 bis 20 Jahre beträgt.

Nachfolgend werden Ausführungsbeispiele der Erfindung anhand einer Zeichnung näher erläutert. Darin zeigen:

Fig. 1    in einem Blockdiagramm den Ablauf des Verfahrens zur Lichtbogenerkennung in einem Bordnetzkabel,
Fig. 2    eine schematische Darstellung zur Erläuterung des Mess- und Auswerteprinzips,
Fig. 3    den Signalverlauf einer Arc-Signal-Gruppe und eines einzelnen Arc-Signals,
Fig. 4    einen typischen Signalverlauf infolge eines Schaltereignisses,
Fig. 5    ein Blockschaltbild eines Schutzschalters in dem der Algorithmus zur Durchführung des Verfahrens implementiert ist, und
Fig. 6    den Schutzschalter in einer perspektivischen Gesamtansicht.

Einander entsprechende Teile sind in allen Figuren mit den gleichen Bezugszeichen versehen.

Die im Bordnetz eines Luftfahrzeugs oder Flugzeugs eingesetzte Spannung $U_B$ beträgt üblicherweise 115V bei einer Netzfrequenz f von 400Hz. Das entsprechende zeitkontinuierliche oder analoge Wechselstromsignal mit derselben Frequenz von 400Hz kann somit nach dem Kosinus-Ansatz in allgemeiner und ungestörter Form, d.h. ohne überlagerte Störungen, beschrieben werden durch:

$$i(t) = \hat{\imath} \cdot \cos (\omega t + \varphi) \tag{1}$$

Dabei sind $\hat{\imath}$ die Amplitude und $\varphi$ die Phase des Stromsignals sowie $\omega$ die Kreisfrequenz, mit $f = \omega/2\pi$ als Netz- oder Wechselstromfrequenz.

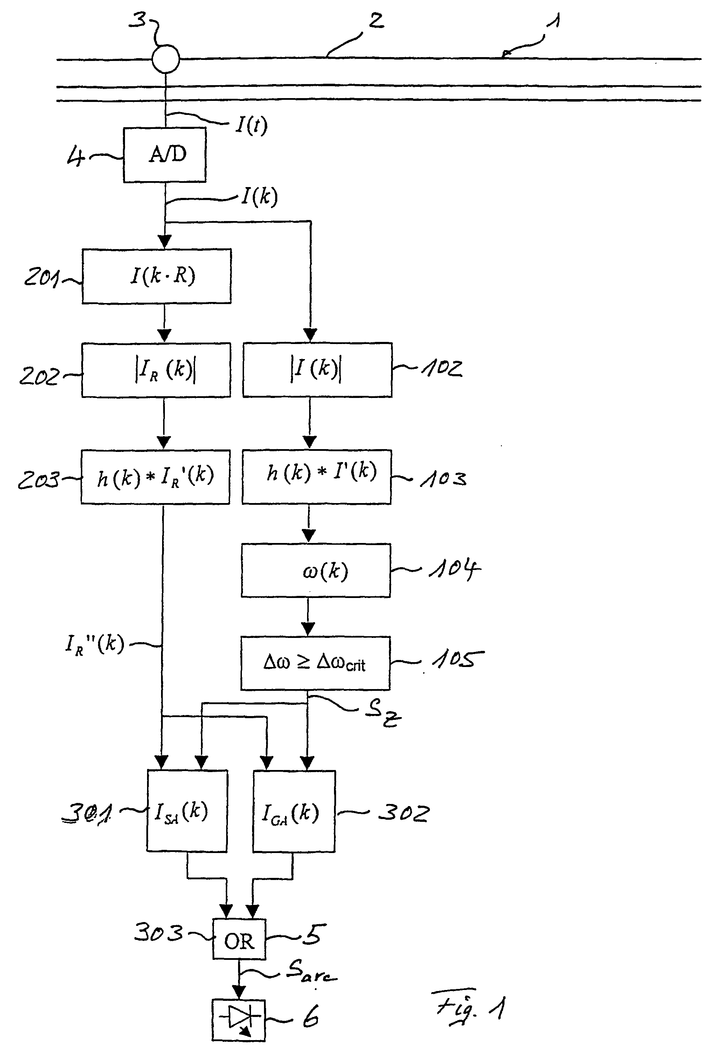

Ausgehend von diesem Ansatz wird gemäß Figur 1 der Strom I(t) in der Versorgungsleitung 2 des Bordnetzes oder eines Bordnetzkabels 1 mittels eines Stromsensors oder -wandlers 3 erfasst. Das erfasste Stromsignal I(t) enthält dabei - zusätzlich zu weiteren Störungen - als Überlagerung auch ein infolge eines Lichtbogens aufgetretenes Arc-Signal. Das erfasste Stromsignal I(t) wird mittels eines Analog-Digital-Wandlers (A/D-Wandler) 4 mit einer Taktfrequenz f = 1/T von z. B. 50kHz abgetastet. Der A/D-Wandler 4 hat dabei eine Auflösung von mindestens 12bit, vorzugsweise 16bit. Bei einer derartigen Taktfrequenz f von 50kHz werden alle 0,02ms die Stromwerte (I(t)-Werte) abgetastet oder ausgelesen, wobei

$$I(k) = I(k \cdot T), \; mit \; k \in \mathbb{Z} \tag{2}$$

ist. Dieses aus dem erfassten kontinuierlichen Stromsignal I(t) mittels des A/D-Wandlers 4 in das zeitdiskrete Signal I(kT) umgewandelte Signal wird mittels des in Fig.1 veranschaulichten Algorithmus verarbeitet bzw. ausgewertet. Dazu wird das Signal I(kT) in einem ersten Programmschritt 102 eines ersten Programmpfades durch Betragsbildung gemäß der Beziehung:

$$I'(k) = |I(k)| \tag{3}$$

quasi gleichgerichtet, d. h. die negative Halbwelle erscheint als positive Halbwelle.

In einem anschließenden Programmschritt 103 erfolgt eine Glättung des Signals I'(k) durch eine digitale Filteroperation mit der Übertragungsfunktion

$$H(z) = \frac{1}{N} \sum_{k=0}^{N-1} z^{-k}$$

$$(4a)$$

und der Impulsantwort

$$h(k) = \left\{ \frac{1}{N}, k = 0 \rightarrow N-1 \right\}$$

$$h(k) = \{0, sonst\}$$

$$(4b)$$

Diese bewirkt eine Verarbeitung des Signals I'(k) gemäß der Faltungs- oder Filteroperation:

$$I''(k) = h(k) * I'(k) = \frac{1}{N} \sum_{i=0}^{N-1} I'(k-i)$$

$$(4c)$$

Dabei ist N = 9, wenn aus 10 Abtastwerten der jeweilige Mittelwert gebildet wird. N gibt somit die entsprechende Fensterbreite des digitalen Filters an. Außerdem entspricht k dem aktuellen Zeitpunkt, während i die zeitlich zurückliegenden Werte angibt. Das digitale Filter bzw. die digitale Filteroperation arbeitet somit in die Vergangenheit, d. h. in kausaler Richtung.

In einem zweiten, parallelen Programmpfad durchläuft das zeitdiskrete Signal I(k) in einem ersten Programmschritt 201 ein Tiefpassfilter, wobei die Anzahl der Abtastwerte nach erfolgter Filterung um z. B. den Faktor R = 10 reduziert ist gemäß der Beziehung:

$$I_R(k) = I(k \cdot R) \tag{5}$$

In den anschließenden Programmschritten 202 und 203 dieses Programmpfades erfolgt wiederum - analog zu den Programmschritten 102 und 103 - zunächst eine Betragsbildung des reduzierten Signals $I_R(k)$ mit dem Ergebnis $I'_R(k)$, wobei

$$I'_R(k) = |I_R(k)| \tag{6}$$

ist. Anschließend erfolgt wiederum eine Glättung des Signals $I'_R(k)$ nach den Beziehungen 4a bis 4c mit dem Ausgangssignal:

$$I_R''(k) = \frac{1}{N} \sum_{i=0}^{N-1} I_R'(k-i)$$

$$(7)$$

Dieses Signal $I''_R(k)$ wird einem Baustein oder Programmschritt 301 zur Bewertung eines einzelnen Arc-Signals oder Lichtbogen-Impulses $I_{SA}(k)$ sowie einem Programmschritt 302 zur Bewertung einer Anzahl oder Gruppe $I_{GA}(k)$ von Are- bzw. Lichtbogen-Signalen zugeführt.

Im ersten Programmpfad wird im Programmschritt 104 die aktuelle Frequenz des Signals I"(k) ermittelt gemäß der allgemeinen Beziehung:

$$2\pi f(k) = \omega(k) = \frac{2}{\Delta T} \arccos \frac{y(kl,r)}{y(k \max)} \tag{8}$$

bzw. gemäß der vollständigen Beziehung:

$$\omega(k) = \frac{1}{T} \frac{(kr - k \max)\cdot\arccos \gamma r + (k \max - kl)\arccos \gamma l}{(kr - k \max)^2 + (k \max - kl)^2} \tag{9}$$

mit

$$\gamma r = \frac{y(kr)}{y(k \max)}, \; \gamma l = \frac{y(kl)}{y(k \max)}, \tag{10}$$

wobei y(k) dem Ausgangssignal I"(k) entspricht.

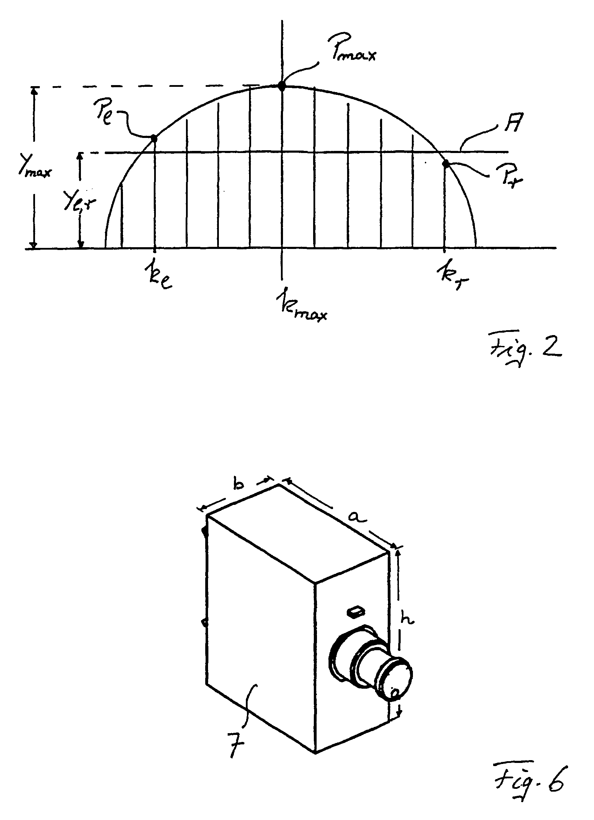

Gemäß dieser Beziehung (9) lässt sich aufgrund der vorgegebenen und damit bekannten Abtastzeit T bzw. Abtastrate f = 1/T aus den Abtastwerten $y(k_l)$, $y(k_r)$ und $y(k_{max})$ - bzw. I"($k_l$), I"($k_r$) und I"($k_{max}$) - an den jeweiligen Abtaststellen oder Zeittakten $k_r$, $k_l$ bzw. $k_{max}$ die aktuelle Frequenz $\omega(k)$ des zeitdiskreten Signals I(kT) und damit des gemessenen Stromverlaufs I(t) ermitteln. Dazu erfolgt eine Interpolation der KosinusFunktion aus drei Punkten oder Abtastwerten, wie dies nachfolgend anhand der Fig. 2 näher erläutert wird.

Bei der zugrundegelegten Abtastzeit von 0,02ms und einer Bordnetzfrequenz von 400Hz ergeben sich 125 Abtastwerte oder Wertepaare (k,y(k)) je Signalperiode. Das aktuelle Signal I(k) lässt sich somit beschreiben durch:

$$I(k) = I(k_{max})\cdot\cos[(k - k_{max})\omega T] \tag{11}$$

wobei $\omega$ die aktuelle Frequenz ist. Die Schätzung der aktuellen Frequenz $\omega$ erfolgt anhand lediglich der drei Punkte:

$$P_l = (k_l, y(k_l))$$

$$P_{max} = (k_{max}, y(k_{max}))$$

$$P_r = (k_r, y(k_r))$$

Bei Verwendung von weniger als drei Punkten müßte eine zur vollständigen Beschreibung der Kosinusfunktion (1) erforderliche Größe, z. B. die Amplitude i(t) oder die Phase $\varphi$, aus einer anderen Operation abgeleitet werden.

Zur Bestimmung der Punkte $P_l$ und $P_r$ wird vorteilhafterweise ein Schwellwert A vorgegeben, bei dessen Überschreiten und bei dessen zeitlich versetztem Unterschreiten der entsprechende Zeit- oder k-Wert $k_l$, $k_r$ des jeweils folgenden Abtastwertes verwendet wird, während als zugehöriger Amplituden- oder y-Wert $y(k_l)$, $y(k_r)$ jeweils der Schwellwert A verwendet wird, so dass gilt:

$$y(k_l) \approx A, \; y(k_r) \approx A \tag{12}$$

Der Schwellwert A kann dabei auch an den jeweils maximalen Strom $I_{max}(t)$ angepaßt werden, indem der Schwellwert A in einem entsprechenden Programmschritt automatisch z. B. auf 10% bis 70% des maximalen Stroms I(t) und damit auf einen in Abhängigkeit vom Leitungsquerschnitt von einem Schutzschalter üblicherweise überwachten Nennstrom eingestellt wird. Zweckmäßig ist auch eine Frequenzerkennung in einem entsprechenden Programmschritt, insbesondere wenn die Wechselstrom- oder Bordnetzfrequenz variabel ist. Eine Frequenzerkennung der aktuellen Frequenz ω kann beispielsweise vor dem ersten Programmschritt 102 und vor oder nach der Abtastung des Mess- oder Stromsignals I(t) mittels eines PLL (Phase Locked Loop) erfolgen.

Im Programmschritt 105 wird diese aus dem zeitdiskreten Stromsignal I(k) ermittelte aktuelle Frequenz ω (k) mit einem eine kritische Frequenz ω'(k) repräsentierenden Schwellwert $\Delta\omega_{crit}$, z. B. 50Hz, verglichen, wobei gilt:

$$\Delta\omega = |\omega - \omega'| \tag{13}$$

Die Frequenz ω(k) repräsentiert dabei die halbe Wechselstrom- bzw. Bordnetzfrequenz (f/2 = 200Hz). Ist $\Delta\omega \geq \Delta\omega_{crit}$, so wird im Programmschritt 105 ein Arc-Flag in Form eines Zustandssignals $S_z$ generiert, das sowohl an den Programmschritt 301 als auch an den Programmschritt 302 weitergegeben wird. Das Zustandssignal $S_z$ ist high ($S_z$ = 1), wenn die aus dem aktuell erfassten Stromverlauf I(k) ermittelte Frequenz ω(k) den Schwellwert überschreitet. Andernfalls ist das Zustandssignal $S_z$ low ($S_z$ = 0).

Während im zweiten Programmpfad mit den Programmschritten oder Funktionsbausteinen 201 bis 203 mit dem reduzierten diskreten Stromsignal $I_R$(k) nahezu alle Informationen des verarbeiteten Signals I(k) enthalten bleiben, werden im ersten Programmpfad mit den Programmschritten oder Funktionsbausteinen 102 bis 105 lediglich die zur Frequenzabschätzung erforderlichen Informationen des Signals I(k) verwertet. Dadurch ist die im ersten Programmpfad zu verarbeitende Impulsrate besonders einfach beherrschbar. Die Verarbeitung der reduzierten Impulsrate im zweiten Programmpfad ist gegenüber dem ursprünglichen diskreten Stromsignal I(k) ebenfalls vergleichsweise einfach beherrschbar, wobei dieser Programm- oder Signalpfad zudem eine genügend genaue Auswertung der im vollständigen Signal gemäß (11) enthaltenen Informationen, insbesondere hinsichtlich mehrerer Signalamplituden $y(k_{max})$, ermöglicht.

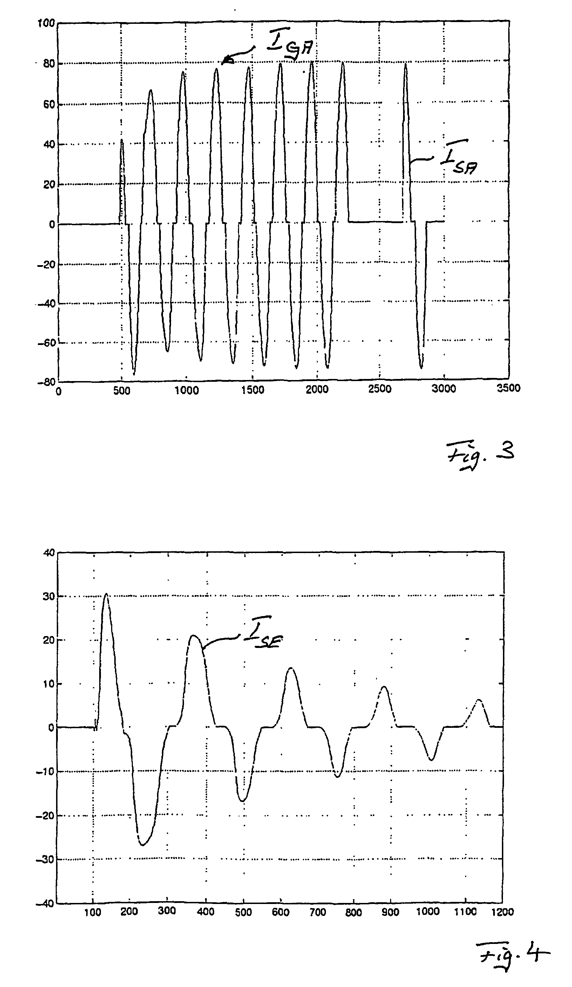

Im Programmschritt 301 werden lediglich die einzelnen Arc-Signale $I_{SA}$(k) ermittelt und analysiert, während im Programmschritt 302 eine Arc-Signalgruppe $I_{GA}$(k) ermittelt bzw. analysiert wird. Figur 3 zeigt einen typischen Arc-Signal-Verlauf einer Arc-Signalgruppe $I_{GA}$(k) (links) und eines einzelnen Arc-Signals $I_{SA}$(k) (rechts).

Im Programmschritt 301 wird anhand des in der Abtastrate reduzierten Signals $I_R$"(k) des Programmschritts 203 und des Zustandssignals $S_z$ des Programmschritts 105 untersucht, ob mindestens L Halbwellen des Signals $I_R$"(k) innerhalb eines vorgebbaren Zeitfensters liegen. Dazu wird die Ableitung des Signals $I_R$"(k) gebildet, d. h. dessen Steigung ermittelt gemäß der Beziehung:

$$grad(k) = I''_R(k) - I''_R(k\text{-}1) \tag{14}$$

Sind $S_z$ = 1 und grad(k) > $grad_{max}$, überschreitet also der Wert grad(k) einen Schwellwert, so wird die entsprechende Halbwelle des Signals $I_R$"(k) als potentielles Arc-Signal angesehen und es wird ein Zähler erhöht. Liegt der Zählerwert innerhalb des Zeitfensters oberhalb von L, so generiert der Programmschritt 301 ein eine Arc-Erfassung repräsentierendes Meldesignal, z. B. high oder 1. Dieses wird einer ODER-Verknüpfung (Programmschritt 303) oder einem logischen ODER-Glied 5 zugeführt, die ein Meldesignal $S_{arc}$ an ein Anzeigeelement 6, beispielsweise in Form einer Leuchtdiode (LED), liefert.

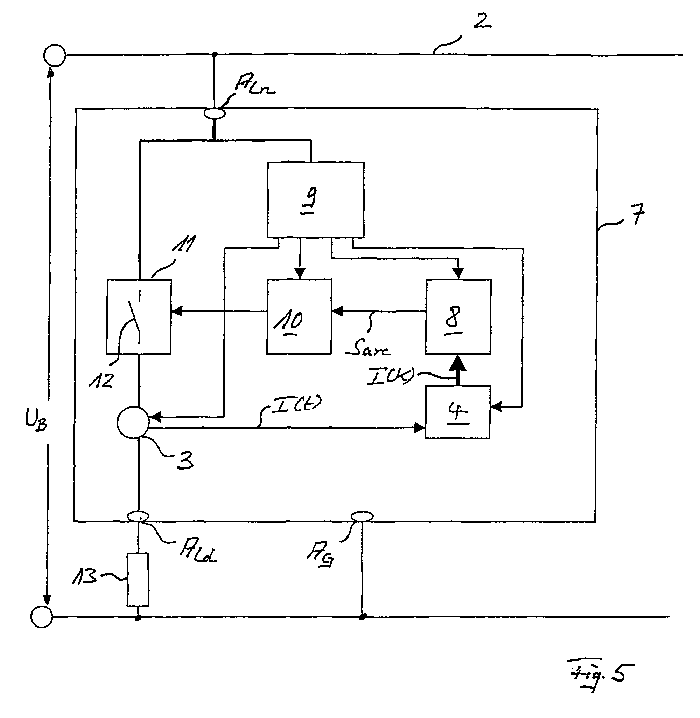

Im Programmschritt 302 wird eine Gruppe $I_{GA}$(k) von Arc-Signalen verglichen mit einem eventuell (gleichzeitig) auftretenden Störsignalverlauf infolge eines verbraucherseitigen Schaltereignisses, dessen typischer Signalverlauf $I_{SE}$ in Figur 4 dargestellt ist. Zwar zeigt ein derartiges Störsignal $I_{SA}$ infolge des Ein- oder Ausschaltens eines über dieses Bordnetzkabel 1 angeschlossenen Verbrauchers oder einer Last einen den Arc-Signalen $I_{GA}$(k) ähnlichen Signalverlauf. Allerdings klingt ein derartiges Störsignal $I_{SA}$ erkanntermaßen nach einer e-Funktion ab, was bei einer typischen Arc-Signalgruppe $I_{GA}$(k) nicht der Fall ist.

Anhand oder aufgrund dieses Abklingverhaltens kann ein derartiges Störsignal infolge von Schaltereignissen daher von einer typischen Arc-Signalgruppe $I_{GA}$(k) unterschieden werden. Dazu erfolgt zunächst eine Bestimmung der Maxima aller Halbwellen der Signale der Arc-Signal-Gruppe $I_{GA}$(k), deren Frequenz ω über der kritischen Frequenz ω' liegen. Anschließend erfolgt die Summation von M aufeinander folgenden Maxima sowie die Bestimmung des Maximums der M Werte und die Bildung des Mittelwertes. Wird ein vorgebbarer Anteil, z. B. 90%, des Mittelwertes erreicht, so wird auf Arc Trakking erkannt und der Programmschritt 302 liefert wiederum ein eine Arc-Erfassung repräsentierendes Meldesignal, z. B. high oder 1. Dieses wird der ODER-Verknüpfung (Programmschritt 303) zugeführt, die das Meldesignal $S_{arc}$ für das Anzeigeelement 6 oder für eine Schutzschalterfunktion (Fig. 5) erzeugt.

Die gesamte Programmfunktion ist vorzugsweise integriert in ein ASIC (Application Specific Interated Circuit), das seinerseits als integraler Bestandteil in einen im Luft- bzw. Raumfahrzeug üblicherweise vorgesehenen Schutzschalter 7 gemäß Fig. 6 eingesetzt ist. Die Abmessungen des Schutzschalters 7 sind an die in diesem Anwendungsfall, nämlich der Luft- und Raumfahrzeuge, üblichen Anforderungen angepasst und betragen ca. a = 50mm, h = 40mm und b = 20mm.

Fig. 5 zeigt die Funktionsbausteine eines solchen Schutzschalters 7 mit integriertem Analog-Digital-Wandler 4 und ASIC-Funktionsbaustein 8, in den der in Fig. 1 veranschaulichte und gemäß des hier beschriebenen Verfahrens arbeitende Algorithmus fest einprogrammiert bzw. implementiert ist. Ein Netzteil 9 liefert den Versorgungsstrom oder die Versorgungsspannung für den Funktionsbaustein 8 und für den diesem vorgeordneten A/D-Wandler 4 sowie für den ebenfalls integrierten Stromsensor 3 und einen Fernauslösebaustein 10 zur Fernauslösung in Form beispielsweise einer Auslösespule. Diese ist mit einer Schutzschalterfunktion 11, insbesondere mit mindestens einem Auslöser, einem Schaltschloss und einem Schaltkontakt 12, gekoppelt. Der Schaltkontakt 12 ist zwischen einen LINE-Anschluss $A_{Ln}$ und einen LOAD-Anschluss $A_{Ld}$ des zusätzlich einen Ground-Anschluss $A_G$ aufweisenden Schutzschalters 7 geschaltet.

Bei Anschluss des Schutzschalters 7 an die Versorgungsleitung 2 des Bordnetzes oder -kabels 1 erfasst der Stromsensor 3 das bei geschlossenem Schaltkontakt 12 über die Schutzschalterfunktion 11 zu einem Aktor, einem Sensor und damit zu einem Bordnetzverbraucher oder allgemein zur Last 13 des Bordnetzes 1 geführte Stromsignal I(t). Dessen Verarbeitung zur Erfassung von Arc-Signalen (Arc Tracking) infolge eines entlang des Bordnetzkabels 1 auftretenden Lichtbogens erfolgt innerhalb des Schutzschalters 7 mittels des A/D-Wandlers 4 und des FPGA-Bausteins 8. Dieser generiert im Falle der beschriebenen Detektion eines Arc Tracking das Meldesignal $S_{arc}$, das zur Anzeige 6 und/oder zum Fernauslösebaustein 10 geführt wird. Dieser liefert ein Auslösesignal $S_A$ an die insbesondere als Leitungsschutz wirksame Schutzschalterfunktion 11, die den Schaltkontakt 12 öffnet und somit die entsprechende Last 13 von der Versorgungsleitung 2 und damit vom Bordnetz 1 trennt.

Der Schutzschalter 7 gewährleistet somit zusätzlich zum konventionellen Überstromschutz im Bordnetz eines derartigen Luftfahrzeugs einen erweiterten Schutz auch vor Störlichtbögen, so dass die vorhandenen Bordinstallationen zuverlässig geschützt sind.

Bezugszeichenliste

| | |
|---|---|
| 1 | Bordnetz |
| 2 | Versorgungsleitung |
| 3 | Stromwandler |
| 4 | A/D-Wandler |
| 5 | ODER-Glied/-Verknüpfung |
| 6 | Anzeigeelement |
| 7 | Schutzschalter |
| 8 | ASIC-Funktionsbaustein |
| 9 | Netzteil |
| 10 | Fernauslöse-Baustein |
| 11 | Schutzschalterfunktion |
| 12 | Schaltkontakt |
| 13 | Last |

| | |
|---|---|
| 102-303 | Programmschritt |

| | |
|---|---|
| I(t) | Wechselstromsignal |
| I(k) | zeitdiskretes Stromsignal |
| $I_{SA}$ | (einzelnes) Arc-Signal |
| $I_{GA}$ | Arc-Signalgruppe |
| $I_{SE}$ | Signalverlauf/Störsignal |
| Sarc | Meldesignal |
| $S_z$ | Zustandssignal |

**Patentansprüche**

1. Verfahren zur Erkennung von Störlichtbögen, auch Arc Tracking genannt, an einem Kabel (1), insbesondere an einem Bordnetzkabel eines Luftfahrzeugs, bei dem ein erfasstes Wechselstromsignal (I(t)) zeitdiskret abgetastet und anhand des dabei gebildeten diskreten Stromsignals (I(k)) durch Interpolation einer Anzahl von Abtastwerten (y(k)) eine den Wechselstromverlauf nachbildende Winkelfunktion (I(k)) ermittelt wird, aus der die aktuelle Wech-

selstromfrequenz ($\omega$) abgeleitet wird, und bei dem aus dem Ergebnis eines Vergleichs der aktuellen Wechselstromfrequenz ($\omega$) mit einer Soll-Frequenz ($\omega'$) auf einen Störlichtbogen geschlossen wird.

2. Verfahren nach Anspruch 1, bei dem zur Ableitung der aktuellen Wechselstromfrequenz ($\omega$) aus der Anzahl der Abtastwerte (y(k)) lediglich der den Maximalwert repräsentierende Abtastwert ($P_{max}$) sowie ein zeitlich vor dem Maximalwert liegender (linker) Abtastwert ($P_l$) und ein zeitlich nach dem Maximalwert liegender (rechter) Abtastwert ($P_r$) herangezogen werden.

3. Verfahren nach Anspruch 2, bei dem dem linken Abtastwert ($P_l$) und dem rechten Abtastwert ($P_r$) der gleiche y-Wert (A) zugeordnet wird.

4. Verfahren nach Anspruch 2 oder 3, bei dem ein Schwellwert (A) vorgegeben wird, der dem diesen überschreitenden Abtastwert ($P_l$) und dem jenen unterschreitenden Abtastwert ($P_r$) als y-Wert zugeordnet wird.

5. Verfahren nach einem der Ansprüche 1 bis 3, bei dem die aktuelle Wechselstromfrequenz ($\omega$) algorithmisch ermittelt wird gemäß der Beziehung:

$$\omega(k) = \frac{1}{T} \frac{(kr - k\,\text{max}) \cdot \arccos \gamma r + (k\,\text{max} - kl) \arccos \gamma l}{(kr - k\,\text{max})^2 + (k\,\text{max} - kl)^2}$$

mit

$$\gamma r = \frac{y(kr)}{y(k\,\text{max})},\; yl = \frac{y(kl)}{y(k\,\text{max})},$$

wobei 1/T die Taktfrequenz und $k_l, k_{max}, k_r$ die den entsprechenden Amplitudenwerten $y(k_l), y(k_{max})$ bzw. $y(k_r)$ zugeordneten Zeittakte ($k \cdot T$) der Abtastwerte (y(k)) sind.

6. Verfahren nach einem der Ansprüche 1 bis 5, bei dem in einem (ersten) Verarbeitungsschritt (102) der Betrag des diskreten Stromsignals (I(k)) gebildet wird.

7. Verfahren nach Anspruch 1 bis 6, bei dem das diskrete Stromsignal (I(k)) in einem Verarbeitungsschritt (201) in der Anzahl der Abtastwerte (I(k)) reduziert wird, und bei dem in einem (ersten) Verarbeitungsschritt (202) der Betrag des reduzierten diskreten Stromsignals ($I_R$(k)) gebildet wird.

8. Verfahren nach einem der Ansprüche 1 bis 7, bei dem in einem (zweiten) Verarbeitungsschritt (103,203) das durch Betragsbildung vorverarbeitete diskrete Stromsignal (I'(k)) und/oder das in der Anzahl der Abtastwerte (I(k)) reduzierte und durch Betragsbildung vorverarbeitete diskrete Stromsignal ($I_R$'(k)) durch eine digitale Filterung gemäß der Faltungsoperation:

$$I''(k) = h(k) * I'(k) = \frac{1}{N} \sum_{i=0}^{N-1} I'(k-i)$$

$$I_R''(k) = \frac{1}{N} \sum_{i=0}^{N-1} I_R'(k-i)$$

weiterverarbeitet wird, wobei N die Fensterbreite der digitalen Filterung und h(k) die aus dieser resultierende Impulsantwort sind, und wobei h(k) = 1/N für k = 0 bis N - 1 und sonst h(k) = 0 ist.

9. Verfahren nach einem der Ansprüche 7 bis 9, bei dem anhand eines aus dem Ergebnis des Frequenzvergleichs abgeleiteten Zustandssignal ($S_Z$) und eines aus dem reduzierten diskreten Stromsignal ($I_R$(k)) abgeleiteten Ausgangssignal ($I''_R$(k)) einzelne Störsignale ($I_{SA}$) und/oder eine Störsignalgruppe ($I_{GA}$) hinsichtlich deren Bildung infolge eines Lichtbogens bewertet werden.

10. Verfahren nach Anspruch 1 bis 9, bei dem ein bei Detektion eines Störlichtbogens erzeugtes Meldesignal ($S_{arc}$) zur Auslösung eines Schutzschalters (7) herangezogen wird, der im Auslösefall eine Last (13) vom Kabel (1) abtrennt.

11. Verfahren nach einem der Ansprüche 1 bis 10, bei dem eine detektierte Arc-Signalgruppe $I_{GA}(k)$ von einem infolge eines Schaltereignisses aufgetretenen Störsignal ($I_{SE}$) unterschieden wird anhand dessen Abklingverhaltens.

12. Vorrichtung zur Erkennung von Störlichtbögen auch Arc Tracking genannt, an einem Kabel (1), insbesondere an einem Bordnetzkabel eines Luftfahrzeugs, mit einem Stromsensor (3) zur Erfassung eines über das Kabel (1) geführten Wechselstromsignals (I(t)) und mit einem Analog-Digital-Wandler (4), der aus dem Wechselstromsignal (I(t)) eine Anzahl von zeitdiskreten Abtastwerten (y(k)) erzeugt, sowie mit einem Funktionsbaustein (8), dessen Algorithmus durch Auswertung ausgewählter Abtastwerte ($y_{lr}, y_{max}$) die aktuelle Wechselstromfrequenz ($\omega$) ermittelt und bei deren Abweichung von einer Soll-Frequenz ($\omega'$) ein Meldesignal ($S_{arc}$) erzeugt.

13. Vorrichtung nach Anspruch 12, bei der als Funktionsbaustein (8) ein ASIC (Application Specific Integrated Circuit) eingesetzt ist.

14. Vorrichtung nach Anspruch 12 oder 13, bei der der Stromsensor (3) und der Analog-Digital-Wandler (4) sowie der Funktionsbaustein (8) in einem Schutzschalter (7) integriert sind, dessen Schutzschalterfunktion (11) bei Empfang des Me(designals ($S_{arc}$) eine Verbindung zwischen einem Eingangsanschluss ($A_{Ln}$) für eine Versorgungsleitung (2) des Kabels (1) und einem Ausgangsanschluss ($A_{ld}$) für eine Last (13) auftrennt.

15. Vorrichtung nach Anspruch 14, bei der ein eingangsseitig mit dem Eingangsanschluss ($A_{Ln}$) verbundenes Versorgungsnetzteil (9) ausgangsseitig mit dem Funktionsbaustein (8) und mit dem Stromsensor (3) verbunden ist.

16. Schutzschalter, insbesondere für das Bordnetz eines Luftfahrzeugs, mit einer Vorrichtung nach Anspruch 12 oder 13 zur Erkennung und Abschaltung von an einem Kabel (1) auftretenden Störlichtbögen.

**Claims**

1. Method for detecting fault arcs, also known as arc tracking, on a cable (1), in particular on an on-board supply system cable of an aircraft, in which a detected AC signal (I(t)) is sampled in a time-discrete manner, and a trigonometric function (I(k)) simulating the AC waveform is determined by interpolation of a number of sampled values (y(k)) using the discrete current signal (I(k)) formed in the process, the present AC frequency ($\omega$) being derived from said trigonometric function (I(k)), and in which a fault arc can be inferred from the result of a comparison of the present AC frequency ($\omega$) with a desired frequency ($\omega'$).

2. Method according to Claim 1, in which, of the number of sampled values (y(k)), only the sampled value ($P_{max}$) representing the maximum value and a (left-hand) sampled value ($P_l$) lying temporally before the maximum value and a (right-hand) sampled value ($P_r$) lying temporally after the maximum value are used to derive the present AC frequency ($\omega$).

3. Method according to Claim 2, in which the left-hand sampled value ($P_l$) and the right-hand sampled value ($P_r$) are assigned the same y value (A).

4. Method according to Claim 2 or 3, in which a threshold value (A) is predetermined which is assigned as the y value to the sampled value ($P_l$) exceeding said threshold value (A) and to the sampled value ($P_r$) falling below said threshold value (A).

5. Method according to one of Claims 1 to 3, in which the present AC frequency ($\omega$) is determined algorithmically in accordance with the following relationship:

$$\omega(k) = \frac{1}{T} \frac{(kr - k\,\text{max})\cdot\arccos \gamma r + (k\,\text{max} - kl)\arccos \gamma l}{(kr - k\,\text{max})^2 + (k\,\text{max} - kl)^2}$$

where

$$yr = \frac{y(kr)}{y(k\,max)}), \; yl = \frac{y(kl)}{y(k\,max)},$$

l/T being the clock frequency and $k_l$, $k_{max}$, $k_r$ being the clock intervals ($k \cdot T$) assigned to the corresponding amplitude values $y(k_l)$, $y(k_{max})$ and $y(k_r)$, respectively, of the sampled values ($y(k)$).

6. Method according to one of Claims 1 to 5, in which in one (a first) processing step (102) the absolute value of the discrete current signal (I(k)) is generated.

7. Method according to Claims 1 to 6, in which the discrete current signal (I(k)) is reduced in the number of sampled values (I(k)) in one processing step (201), and in which in one (a first) processing step (202) the absolute value of the reduced discrete current signal ($I_R$(k)) is generated.

8. Method according to one of Claims 1 to 7, in which in one (a second) processing step (103, 203) the discrete current signal (I'(k)) preprocessed by absolute-value generation and/or the discrete current signal ($I_R$'(k)), which is reduced in the number of sampled values (I(k)), and is preprocessed by absolute-value generation, is processed further by digital filtering in accordance with the following convolution operation:

$$I''(k) = h(k) \cdot I'(k) = \frac{1}{N}\sum_{i=0}^{N-1} I'(k-i)$$

$$I_R''(k) = \frac{1}{N}\sum_{i=0}^{N-1} I_R'(k-i) \;,$$

N being the window width of the digital filtering and h(k) being the pulse response resulting from this, and h(k) = l/N for k = 0 to N-1 and otherwise h(k) = 0.

9. Method according to one of Claims 7 to 9, in which individual fault signals ($I_{SA}$) and/or a fault signal group ($I_{GA}$) are evaluated in terms of their formation as a result of an arc on the basis of a state signal ($S_z$) derived from the result of the frequency comparison and an output signal ($I''_R$(k)) derived from the reduced discrete current signal ($I_R$(k)).

10. Method according to Claims 1 to 9, in which an alarm signal ($S_{arc}$) produced when a fault arc is detected is used to trigger a circuit breaker (7) which isolates a load (13) from the cable (1) when triggered.

11. Method according to one of Claims 1 to 10, in which a detected arc signal group ($I_{GA}$(k)) is differentiated from a fault signal ($I_{SE}$), occurring as a result of a switching event, on the basis of the decay behaviour of said fault signal ($I_{SE}$).

12. Device for detecting fault arcs, also known as arc tracking, on a cable (1), in particular on an on-board supply system cable of an aircraft, having a current sensor (3) for detecting an AC signal (I(t)), fed via the cable (1), and having an analogue-to-digital converter (4), which produces a number of time-discrete sampled values (y(k)) from the AC signal (I(t)), and having a functional module (8) whose algorithm determines the present AC frequency ($\omega$) by evaluating selected sampled values ($y_{lr}$, $y_{max}$), and, in the event of a discrepancy between said present AC frequency ($\omega$) and a desired frequency ($\omega'$), produces an alarm signal ($S_{arc}$).

13. Device according to Claim 12, in which an ASIC (application specific integrated circuit) is used as the functional module (8).

14. Device according to Claim 12 or 13, in which the current sensor (3) and the analogue-to-digital converter (4) and the functional module (8) are integrated in a circuit breaker (7), whose circuit breaker operation (11) isolates a connection between an input connection ($A_{Ln}$) for a power supply line (2) of the cable (1) and an output connection

($A_{ld}$) for a load (13) when the alarm signal ($S_{arc}$) is received.

**15.** Device according to Claim 14, in which a power supply unit (9) connected on the input side to the input connection ($A_{Ln}$) is connected on the output side to the functional module (8) and to the current sensor (3).

**16.** Circuit breaker, in particular for the on-board supply system of an aircraft, having a device according to Claim 12 or 13 for detecting and isolating fault arcs occurring on a cable (1).

**Revendications**

**1.** Procédé pour identifier des arcs électriques parasites, également désignés par Arc Tracking, sur un câble (1), notamment sur un câble du réseau de bord d'un avion, selon lequel un signal de courant alternatif détecté (I(t)) est échantillonné d'une manière discrète dans le temps, et sur la base du signal de courant discret formé (I(k)) est déterminée, par interpolation d'un nombre de valeurs d'échantillonnage (y(k)), une fonction angulaire (I(k)), qui simule l'allure du courant alternatif et à partir de laquelle est dérivée la fréquence actuelle ($\omega$) du courant alternatif, et selon lequel on conclut à la présence d'un arc électrique parasite à partir du résultat d'une comparaison de la fréquence actuelle ($\omega$) du courant alternatif à une fréquence de consigne ($\omega'$).

**2.** Procédé selon la revendication 1, selon lequel pour dériver la fréquence actuelle ($\omega$) du courant alternatif à partir du nombre des valeurs d'échantillonnage (y(k)), on utilise uniquement la valeur d'échantillonnage ($P_{max}$) qui représente la valeur maximale, ainsi qu'une valeur d'échantillonnage (de gauche) ($P_l$) située dans le temps en amont de la valeur maximale, et une valeur d'échantillonnage (de droite) ($P_r$) située dans le temps en aval de la valeur maximale.

**3.** Procédé selon la revendication 2, selon lequel la même valeur y (A) est associée à la valeur d'échantillonnage de gauche ($P_l$) et à la valeur d'échantillonnage de droite ($P_r$).

**4.** Procédé selon la revendication 2 ou 3, selon lequel une valeur de seuil (A) est prédéterminée, cette valeur étant associée en tant que valeur y à la valeur d'échantillonnage ($P_l$) dépassant cette valeur de seuil, et à la valeur d'échantillonnage ($P_r$) tombant au-dessous de cette valeur de seuil.

**5.** Procédé selon l'une des revendications 1 à 3, selon lequel la fréquence actuelle ($\omega$) du courant alternatif est déterminée par un algorithme conformément à la relation :

$$\omega(k) = \frac{1}{T} \cdot \frac{(kr - kmax) \cdot \arccos \gamma r + kmax - k_l) \arccos \gamma_l}{(k_r - kmax)^2 + (kmax - kl)^2}$$

avec

$$\gamma_r = \frac{y(kr)}{y(kmax)}, \ \gamma_l = \frac{y(kl)}{y(kmax)},$$

1/T représentant la fréquence de cadence et $k_l$, $k_{max}$, $k_r$ représentant les cadences temporelles (k.T), associées aux valeurs d'amplitude correspondantes $y(k_l)$, $y(k_{max})$ et $y(k_r)$, des valeurs d'échantillonnage (y(k)).

**6.** Procédé selon l'une des revendications 1 à 5, selon lequel la valeur absolue du signal de courant discret (I(k)) est formée lors d'une (première) étape de traitement (102).

**7.** Procédé selon les revendications 1 à 6, selon lequel le signal de courant discret (I(k)) est réduit lors d'une étape de traitement (201) en ce qui concerne le nombre des valeurs d'échantillonnage (I(k)), et dans lequel lors d'une (première) étape de traitement (202), la valeur absolue du signal de courant discret réduit ($I_R$(k)) est formée.

**8.** Procédé selon l'une des revendications 1 à 7, selon lequel lors d'une (seconde) étape de traitement (103, 203), le signal de courant discret (I'(k)) prétraité par la formation de la valeur absolue, et/ou le signal de courant discret ($I_R'$(k)) réduit en ce qui concerne le nombre des valeurs d'échantillonnage (I(k)) est prétraité par la formation de la valeur absolue, et est traité ensuite au moyen d'un filtrage numérique conformément à l'opération de convolution :

$$I''(k) = h(k) * I'(k) = \frac{1}{N} \sum_{i=0}^{N-1} I'(k-i)$$

$$I_R''(k) = \frac{1}{N} \sum_{i=0}^{N-1} I_R'(k-i)$$

N représentant la largeur de fenêtre du filtrage numérique et h(k) la réponse impulsionnelle qui résulte, avec h(k) = 1/N pour k = 0 à N - 1 et, sinon, h(k) = 0.

**9.** Procédé selon l'une des revendications 7 à 9, selon lequel des signaux parasites individuels ($I_{SA}$) et/ou un groupe de signaux parasites ($I_{GA}$) sont évalués, en ce qui concerne leur formation en raison d'un arc électrique, sur la base d'un signal d'état ($S_Z$) dérivé du résultat de la comparaison de fréquences et sur la base d'un signal de sortie ($I''_R(k)$) dérivé du signal du courant de discret réduit ($I_R(k)$).

**10.** Procédé selon les revendications 1 à 9, selon lequel un signal de signalisation ($S_{arc}$) produit lors de la détection d'un arc électrique parasite, est utilisé pour déclencher un disjoncteur (7), qui, dans le cas d'un déclenchement, sépare une charge (13) du câble (1).

**11.** Procédé selon l'une des revendications 1 à 10, selon lequel un groupe de signaux d'arc détectés $I_{GA}(k)$ devient différent d'un signal parasite ($I_{SE}$) apparu en raison d'un événement de commutation, sur la base de son comportement de décroissance.

**12.** Dispositif pour identifier des arcs électriques parasites, également désignés sous l'expression Arc Tracking, sur un câble (1), notamment sur un câble du réseau de bord d'un avion, comportant un capteur de courant (3) pour détecter un signal de courant alternatif (I(t)) transmis par- l'intermédiaire du câble (1), et un convertisseur analogique/numérique (4), qui produit à partir du signal de courant alternatif (I(t)) un nombre de valeurs d'échantillonnage discrètes dans le temps (y(k)), ainsi qu'un module fonctionnel (8), dont l'algorithme détermine, par évaluation de valeurs d'échantillonnage sélectionnées ($y_{lr}$, $y_{max}$), la fréquence actuelle du courant alternatif ($\omega$) et, dans le cas d'un écart par rapport à une fréquence de consigne ($\omega'$), produit un signal de signalisation ($S_{arc}$).

**13.** Dispositif selon la revendication 12, selon lequel on utilise comme module fonctionnel (8) un circuit ASIC (Application Specific Integrated Circuit, c'est-à-dire circuit intégré spécifique à l'application).

**14.** Dispositif selon la revendication 12 ou 13, selon lequel le capteur de courant (3) et le convertisseur analogique/numérique (4) ainsi que le module fonctionnel (8) sont intégrés dans un disjoncteur (7), dont la fonction de disjoncteur (11) interrompt, lors de la réception du signal de signalisation ($S_{arc}$), une liaison entre une borne d'entrée ($A_{Ln}$) pour une ligne d'alimentation (2) du câble (1) et une borne de sortie ($A_{ld}$) pour une charge (13).

**15.** Dispositif selon la revendication 14, dans lequel une partie de réseau d'alimentation (9), reliée côté entrée à la borne d'entrée ($A_{Ln}$), est reliée côté sortie au module fonctionnel (8) et au capteur de courant (3).

**16.** Disjoncteur, notamment pour le réseau de bord d'un avion, comportant un dispositif selon la revendication 12 ou 13 pour identifier et interrompre des arcs électriques parasites apparaissant sur un câble (1).

Fig. 1

Fig. 2

Fig. 6

$I_{SA}$

$I_{SA}$

Fig. 3

$I_{SE}$

Fig. 4

Fig. 5